# EUROPEAN PATENT APPLICATION

(11) **EP 2 508 470 A2**
(43) Date of publication of application: **10.10.2012**
(21) Application number: 10833605.8
(22) Date of filing: 29.11.2010
(51) Int. Cl.: B82B 3/00

(54) **ARRANGEMENT APPARATUS AND ARRANGEMENT METHOD FOR FORMING NANO PARTICLES IN SHAPE OF PILLAR**

(30) Priority: 30.11.2009 KR 20090117179
(71) Applicant: Industry-University Cooperation Foundation Sogang University, Seoul 121-742 (KR)
(72) Inventor: YOON, Kyung Byung, Seoul 110-847 (KR); SON, Phil Kook, Busan 609-768 (KR)
(74) Representative: TER MEER - STEINMEISTER & PARTNER GbR
(86) International application number: PCT/KR2010/008493
(87) International publication number: WO 2011/065793

(57) **Abstract**

Disclosed is an apparatus and method for arranging nanoparticles in a column shape by simultaneously inserting the nanoparticles into respective nanogrooves of a substrate with a nanogroove array.

## Description

### Technical Field

The present invention relates to an apparatus and method for arranging nanoparticles, and more particularly, to an apparatus and method for systematically arranging nanoparticles.

### Background Art

Arranging nanoparticles in a specific array is a very important technology field of up-to-date science. In order to obtain the array of nanoparticles arranged for high precision material and apparatus, it needs to arrange the nanoparticles in the array without large defect above several mm, and to perfectly control crystal alignment and lattice symmetry.

A general method for arranging nanoparticles is arranging nanoparticles on a substrate. According to the prior art, if two or more layers of the nanoparticles are made by deposition, the nanoparticles of the upper layer may be positioned onto an interstitial point formed by the three or more nanoparticles of the lower layer.

However, for various applications, it requires that the nanoparticles of the upper layer be positioned right above the nanoparticles of the lower layer.

Furthermore, there is a need to fabricate a nanoparticle array obtained by sequentially arranging nanoparticles in a column shape.

However, a method for depositing nanoparticles vertically has not yet developed.

### Disclosure

### Technical Problem

It is an object of the present invention to provide an apparatus and method for providing a large amount of nanoparticles simultaneously at precise positions, and systematically arranging nanoparticles in a column shape.

### Technical Solution

To achieve these objects and other advantages and in accordance with the purpose of the invention, as embodied and broadly described herein, an apparatus for arranging nanoparticles comprises a nanoparticle transfer substrate having an upper substrate to which nanoparticles are to be attached; a nanoparticle receiving substrate having a lower substrate confronting the upper substrate, wherein the nanoparticles attached to the upper substrate are separated therefrom and are to be positioned on the lower substrate; a plurality of nanogrooves in the lower substrate, the nanogrooves inducing the nanoparticles to be arranged at predetermined positions; and a sensor for sensing a distance between the upper substrate and the lower substrate, and positions of the nanoparticles and nanogrooves.

In addition, the apparatus comprises a CCD (charge coupled device) for adjusting an interval between the upper substrate and the lower substrate.

Also, the upper and lower substrates are respectively attached to upper and lower multistages capable of moving three-dimensionally.

Also, the upper and lower substrates have patterned shapes.

Furthermore, the apparatus comprises an SEM (scanning electron microscopy) for photographing the patterned shape to sense the position of the respective nanoparticles and nanogrooves.

Also, the upper and lower substrates are formed of metal, semiconductor, or insulator.

Also, a width of the nanogroove is about 10 ∼ 10,000nm, and a height of nanogroove is about 30 ∼ 100,000nm.

Also, a material for forming the nanogroove includes photoresistor, polymer, silicon substrate, or electrode material.

The width of nanogroove is within a range of 85 ∼ 95% of the average diameter of nanoparticle.

The average diameter of nanoparticle is about 10 ∼ 10,000nm.

The average diameter of nanoparticle is within a range of 85 ∼ 95% of the width of nanogroove.

Also, three or more sensors are provided on each of the upper and lower multistages.

The upper substrate is smaller than the lower substrate in size.

In another aspect of the present invention, a method for arranging nanoparticles comprises preparing a nanoparticle transfer substrate provided with an upper substrate whose one surface has nanoparticles to be attached thereto; preparing a nanoparticle receiving substrate provided with a lower substrate whose one surface has plural nanogrooves to be formed therein; bringing the upper and lower substrates close to each other; measuring a distance between the upper and lower substrates, and sensing pattern positions of the upper and lower substrates by the use of sensor; and separating the nanoparticles from the upper substrate, and positioning the separated nanoparticles in the plural nanogrooves.

Also, the processes for preparing the nanoparticle transfer substrate and preparing the nanoparticle receiving substrate include preliminary measurement processes.

Each of the upper and lower substrates has a predetermined-sized pattern shape therein.

The process for bringing the upper and lower substrates close to each other includes adjusting an interval between the upper and lower substrates by the use of CCD (charge coupled device).

The processes for measuring the distance between the upper and lower substrates, and sensing the pattern position of the upper and lower substrates are carried out through the use of three or more sensors provided in each of upper and lower sides.

The process for sensing the pattern position of the upper and lower substrates is carried out through the use of SEM (scanning electron microscopy).

Furthermore, the process comprises forming multiple layers of nanoparticles in a method of depositing the nanoparticles in the plural nanogrooves by repeatedly carrying out the above processes.

The multiple layers of nanoparticles include two or more layers.

Additionally, the process comprises mutually bonding the multiple layers of nanoparticles.

The process for separating the nanoparticles from the upper substrate, and positioning the separated nanoparticles in the plural nanogrooves includes inserting the nanoparticles into the plurality of nanogrooves, and applying heat to the plurality of nanogrooves so as to stably hold the nanoparticles therein by a volume expansion.

The process for separating the nanoparticles from the upper substrate, and positioning the separated nanoparticles in the plural nanogrooves includes forcibly inserting the nanoparticles into the plurality of nanogroove whose width is within a range of 85 ∼ 95% of the average diameter of nanoparticle.

The nanoparticle is formed of metal, semiconductor, or insulator.

The nanoparticle is formed in shape of sphere, ellipse, pentagonal column, hexagonal column, heptangular column, octagonal column, circular column, hexahedron, hexagonal column having rounded corners, or hexahedron having rounded corners.

### Advantageous Effects

Accordingly, the present invention has the following advantages.

According to the present invention, a large amount of nanoparticles may be arranged simultaneously at precise positions, and deposited in a linear shape.

Also, a column-shaped structure obtained by depositing the nanoparticles according to the present invention may be used for fabricating a new type of photonic crystal.

Also, a linear-shaped deposition structure of the nanoparticles according to the present invention may be used for fabricating wave guide.

In addition, a linear-shaped deposition structure of the nanoparticles according to the present invention may be used as photocatalytic.

### Description of Drawings

FIG. 1 is a perspective view of an apparatus for arranging nanoparticles according to one embodiment of the present invention.
FIG. 2 is a cross sectional view of an apparatus for arranging nanoparticles according to one embodiment of the present invention.
FIG. 3 illustrates a surface of an upper substrate according to one embodiment of the present invention.
FIG. 4 illustrates a surface of a lower substrate according to one embodiment of the present invention.
FIG. 5 is a schematic view showing a sensor position according to one embodiment of the present invention.
FIG. 6 is a schematic view showing a provided CCD according to one embodiment of the present invention.
FIG. 7 is a schematic view of a process for arranging nanoparticles in a single-layered structure according to one embodiment of the present invention.
FIG. 8 is a schematic view of a process for separating nanoparticles according to one embodiment of the present invention.
FIG. 9 is a schematic view of a process for arranging nanoparticles in a double-layered structure according to one embodiment of the present invention.

### Mode for Invention

It will be apparent to those skilled in the art that various modifications and variations can be made in the present invention without departing from the spirit or scope of the inventions. Thus, it is intended that the present invention covers the modifications and variations of this invention provided they come within the scope of the appended claims and their equivalents.

Hereinafter, an apparatus for arranging nanoparticles according to one embodiment of the present invention will be explained in detail with reference to the accompanying drawings.

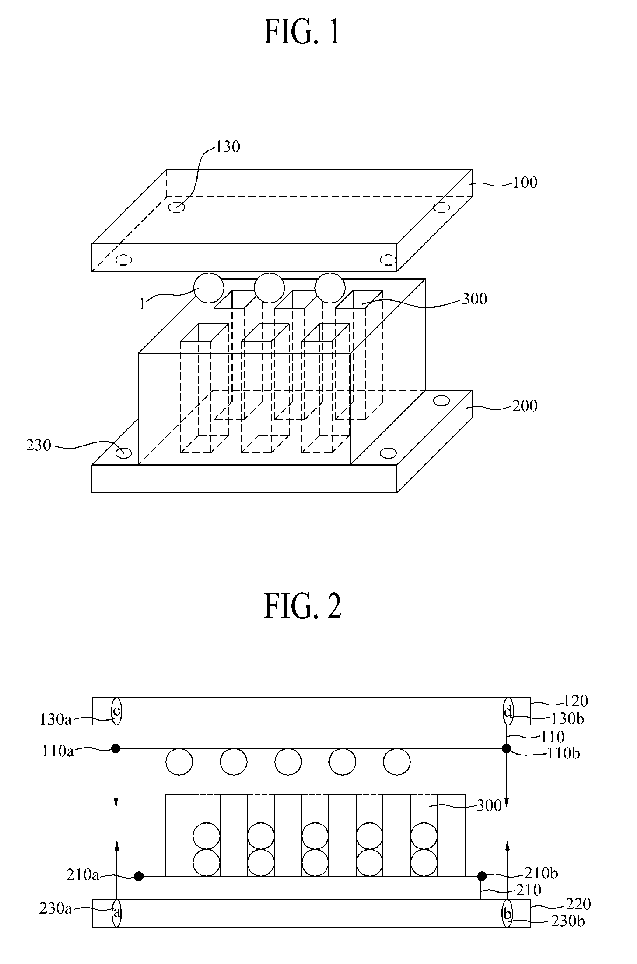

FIG. 1 is a perspective view of an apparatus for arranging nanoparticles 1 according to one embodiment of the present invention.

As shown in FIG. 1, the apparatus for arranging nanoparticles 1 according to one embodiment of the present invention includes a nanoparticle transfer substrate 100, a nanoparticle receiving substrate 200, nanogrooves 300, and sensors 130 and 230.

As shown in FIG. 2, the nanoparticle transfer substrate 100 includes an upper multistage 120 and an upper substrate 110.

The upper multistage 120 is connected with a driving means (not shown) so that the upper multistage 120 is capable of moving three-dimensionally. That is, the upper multistage 120 is formed of 6-axis stage, which moves in the x-axis, y-axis, and z-axis directions. Thus, the upper multistage 120 is capable of moving both in the left-right direction and upper-lower direction.

The upper multistage 120 may be nano-level stage or micro-level stage. Based on the size of nanoparticle 1, the upper multistage 120 may be selectively provided of the nano-level stage or micro-level stage. The nano-level stage generally has about 1nm resolution, and moves about 300µm at maximum. The micro-level stage generally has about 1µm resolution, and moves about 100mm at maximum.

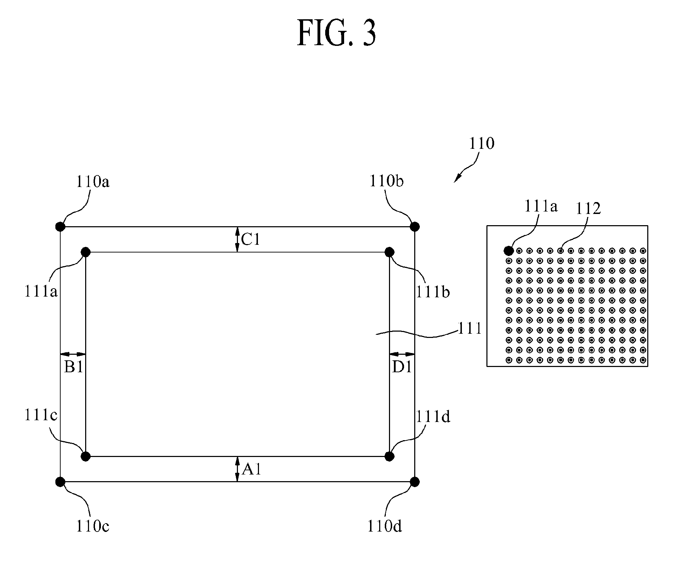

As shown in FIG. 3, an upper pattern 111 is formed on one surface of the upper substrate 110, wherein the nanoparticles 1 are to be attached to one surface of the upper pattern 111. The upper pattern 111 may be formed in such a shape that plural receiving grooves 112 for receiving the nanoparticles 1 therein are provided at fixed intervals. On the upper substrate 110, a central portion having the upper pattern 111 is provided at a constant interval from a circumferential portion having no upper pattern 111. That is, the circumferential portion having no upper pattern 111 may surround the central portion having the upper pattern 111, and each side of the central portion having the upper pattern 111 may be provided at a constant interval from each corresponding side of the circumferential portion having no upper pattern 111. For example, the upper substrate 110 may be fabricated in such a manner that a distance (A1, B1, C1, D1) between each side of the upper pattern 111 of 100 × 100mm² square and each corresponding side of the circumferential portion having no upper pattern 111 is 5µm.

As shown in FIG. 2, the nanoparticle receiving substrate 200 confronts the nanoparticle transfer substrate 100. The nanoparticle receiving substrate 200 includes a lower multistage 220 and a lower substrate 210.

Like the above upper multistage 120, the lower multistage 220 is also connected with the driving means (not shown) so that the lower multistage 220 is capable of moving three-dimensionally.

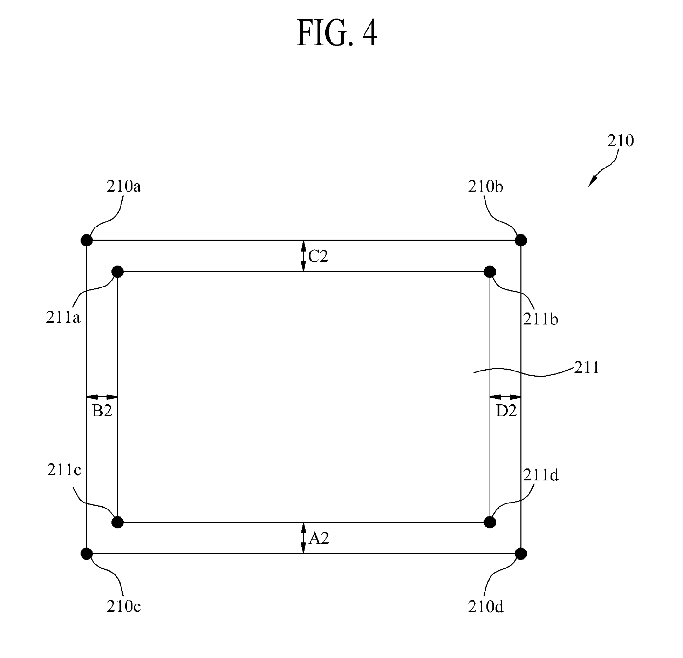

As shown in FIG. 4, a lower pattern 211 is formed on one surface of the lower substrate 210, which confronts the upper substrate 110. In the lower pattern 211, there are plural nanogrooves 300 provided at fixed intervals. Each nanoparticle is inserted into and received in each nanogroove 300. The entire lower pattern 211 of the lower substrate 210 may be similar to the entire upper pattern 111 of the upper substrate 110. That is, each side of a central portion having the lower pattern 211 may be provided at a constant interval from each corresponding side of a circumferential portion having no lower pattern 211. For example, the lower substrate 210 may be fabricated in such a manner that a distance (A2, B2, C2, D2) between each side of the lower pattern 211 of 95 × 95mm² square and each corresponding side of the circumferential portion having no lower pattern 211 is 5µm. Thus, in comparison to the above upper substrate 110, each length and width of the lower substrate 210 is 5mm shorter than each length and width of the upper substrate 110. This enables to sense and measure the precise position of each substrate by the use of upper and lower sensors 130 and 230 provided in the nanoparticle transfer substrate 100 and nanoparticle receiving substrate 200 without any interference.

The apparatus for arranging nanoparticles according to the present invention may further include a control means (not shown), which is connected with the nanoparticle transfer substrate 100 and nanoparticle receiving substrate 200. The control means obtains position information about the nanoparticle transfer substrate 100 and nanoparticle receiving substrate 200, and controls the position of upper and lower multistages 120 and 220.

The apparatus for arranging nanoparticles 1 may further include a vacuum holder (not shown), provided on the upper and lower multistages 120 and 220, for holding the upper substrate 110 and lower substrate 210.

The upper substrate 110 and lower substrate 210 may be formed of metal, semiconductor or insulator to correspond with the nanoparticle 1.

The lower pattern 211 with the nanogroove 300 enables to hold and arrange a large amount of nanoparticles at precise positions. If a multi-layered structure is formed by the nanoparticles 1 deposited in a column-shaped line, the lower pattern 211 with the nanogroove 300 supports the multi-layered structure, to thereby prevent the multi-layered structure from being destroyed.

The width of nanogroove 300 is about 10 ∼ 10,000nm, and the height of nanogroove 300 is about 30 ∼ 100,000nm. If the width of nanogroove 300 is less than 10nm, the nanogroove 300 may be damaged during the process for forming the multi-layered structure due to inferior form stability. Meanwhile, if the width of nanogroove 300 is more than 10,000nm, it may be inappropriate for mass production due to low integration. Also, if the height of nanogroove 300 is less than 30nm, it is difficult to stably support the nanoparticles 1 deposited. If the height of nanogroove 300 is more than 100,000nm, the nanogroove 300 is unnecessarily high, which might cause the increase of production cost.

The width of nanogroove 300 may be within a range of 85 ∼ 95% of the average diameter of nanoparticle 1. This is for easily separating the nanoparticles 1 from the upper substrate 110 by stably holding the nanoparticles 1 inside the nanogroove 300 during the process for separating the nanoparticles 1 from the upper substrate 110.

The lower pattern 211 with the nanogroove 300 may be photoresistor, polymer, silicon substrate, or electrode material, but not limited to those described above.

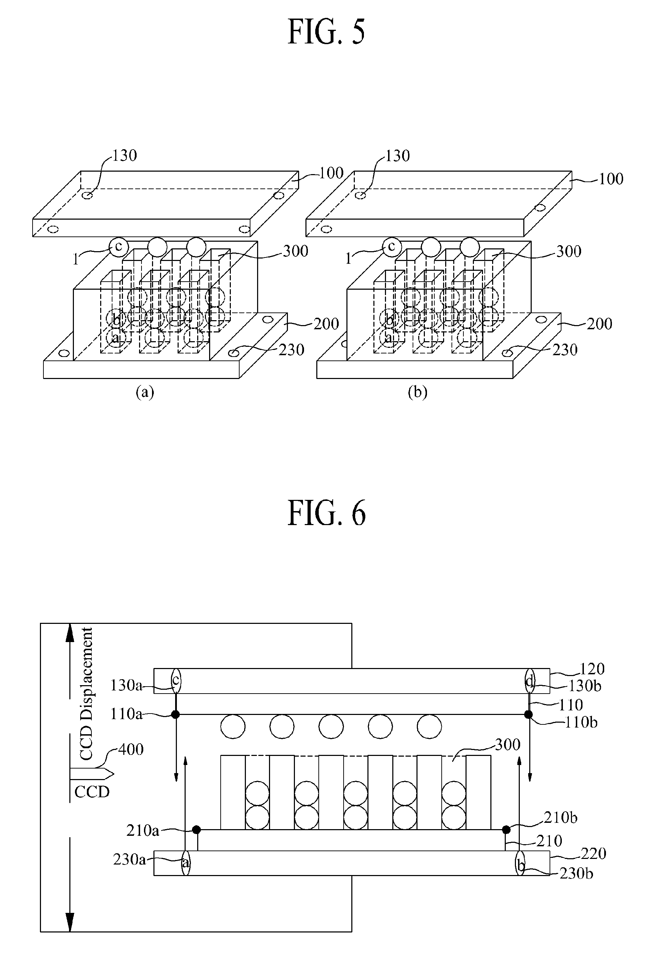

As shown in FIGs. 2 and 5, the sensors 130 and 230 are respectively provided in the lower surface of the upper multistage 120 and the upper surface of the lower multistage 220, which are formed to confront each other. The respective sensors 130 and 230 sense the confronting corner positions of the upper and lower substrates 110 and 210, and also measure the distance. Preferably, three or more sensors are provided for each of the upper and lower multistages 120 and 220. If providing only two sensors for each of the upper and lower multistages 120 and 220, the two corners corresponding the above two sensors can be precisely sensed and measured, but the precise position of the other two corners cannot be sensed and measured. Thus, it is impossible to precisely position the nanoparticles 1 inside the nanogroove 300. For example, as shown in FIG. 5, three or four sensors 130 or 230 may be provided on each confronting surface of the upper and lower multistage 120 and 220.

FIG. 2 shows that the respective sensors 130a, 130b, 230a, and 230b sense and measure the position when the four sensors 130, 130b, 230a, and 230b are provided at the respective corners in each of the upper and lower multistages 120 and 220. As shown in FIG. 2, the upper sensor 'c' 130a senses the position of the left corner 210a in the lower substrate 210; the upper sensor 'd' 130b senses the position of the right corner 210b in the lower substrate 210; the lower sensor 'a' 230a senses the position of the left corner 110a in the upper substrate 110; and the lower sensor 'b' 230b senses the position of the right corner 110b in the upper substrate 110. Accordingly, the respective sensors 130a, 130b, 230a, and 230b sense the position of corners, and measures the distance.

The apparatus for arranging nanoparticles according to the present invention may include scanning electron microscopy (SEM). The shape of upper pattern 111 in the upper substrate 110 is photographed by the SEM. Then, as shown in FIG. 3, the photographed result may be used for sensing the respective corners 111a, 111b, 111c, and 111d of the upper pattern 111 from the respective corners 110a, 110b, 110c, and 110d of the upper substrate 110. Also, as shown in FIG. 4, the photographed result may be used for sensing the respective corners 211a, 211b, 211c, and 211d of the lower pattern 211 from the respective corners 210a, 210b, 210c, and 210d of the lower substrate 210. That is, the position of nanoparticle 1 can be corrected precisely by comparing the shape of the upper substrate 110 previously measured by the use of SEM with the virtually measured shape of the upper substrate 110, whereby the specific eight positions of the upper substrate 110 and lower substrate 210 may be precisely sensed within an error range of 5nm.

The apparatus for arranging nanoparticles according to the present invention may further include charge coupled device (CCD) 400 for checking horizontality and initial position. The CCD 400 measures a distance between the upper substrate 110 and the lower substrate 210 by the use of laser sensor, and adjusts the up-and-down movement of the upper substrate 110 according to the measured distance. After the distance between the upper substrate 110 and the lower substrate 210 is adjusted to about 1µm by the use of CCD 400, the distance between the upper substrate 110 and the lower substrate 210 is again adjusted to the nano-level by the use of sensors 130 and 230 provided in the aforementioned upper and lower multistages 120 and 220. Meanwhile, the CCD 400, which is connected with the aforementioned control means (not shown), obtains the position information about the upper substrate 110 and the lower substrate 210, and controls the position of multistage.

The nanoparticle 1 may be formed of metal, semiconductor or insulator, wherein the average diameter of nanoparticle 1 may be 10 ∼ 10,000nm. If the average diameter of nanoparticle 1 is less than 10nm, it might cause difficulty in controlling the process. Meanwhile, if the average diameter of nanoparticle 1 is more than 10,000nm, artificial photosynthesis efficiency may be lowered due to the low integration.

The nanoparticle 1 is not limited to a specific shape. The nanoparticle 1 may be formed in shape of sphere, ellipse, pentagonal column, hexagonal column, heptangular column, octagonal column, circular column, hexahedron, hexagonal column having rounded corners, or hexahedron having rounded corners. To correspond with the shape of nanoparticle 1, the shape of nanogroove 300 may be the same as the shape of nanoparticle 1.

The average diameter of nanoparticle 1 may be within a range of 85 ∼ 95% of the width of nanogroove 300. When the lower pattern 211 with the nanogroove 300 is heated, the lower pattern 211 is expanded so that the width of nanogroove 300 is decreased, to thereby tightly hold the nanoparticles 1 inside the nanogroove 300.

A method for arranging nanoparticles according to the present invention will be described in detail with reference to the accompanying drawings.

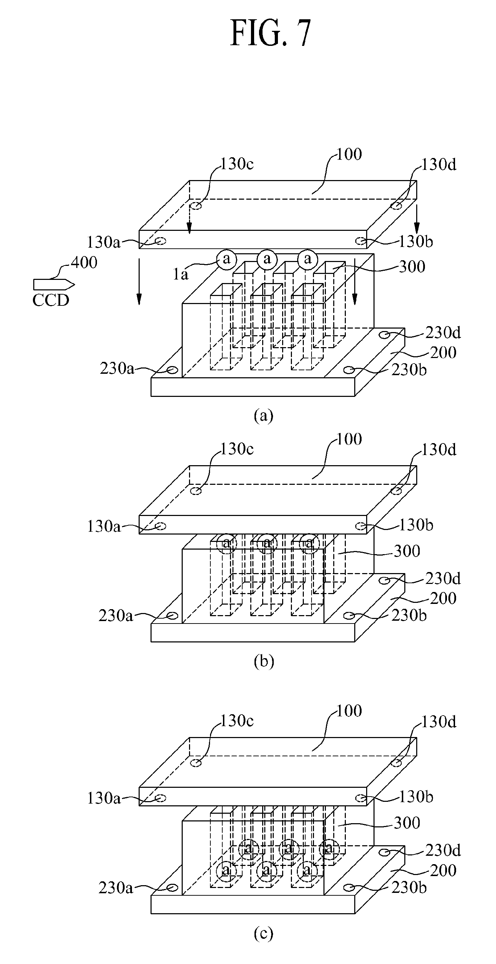

According to one embodiment of the present invention, there is shown a method for arranging the nanoparticles 1 in a single layer. FIG. 7 is a schematic view of a process for arranging the nanoparticles 1 in a single-layered structure according to one embodiment of the present invention.

First, a preparing process is carried out. The preparing process may include sub-processes for preparing the nanoparticle transfer substrate 100, and preparing the nanoparticle receiving substrate 200.

The sub-process for preparing the nanoparticle transfer substrate 100 may be carried out by attaching the upper substrate 110 to the upper multistage 120. The upper pattern 111 is formed on the lower surface of the upper substrate 110. In the upper pattern 111, a large amount of nanoparticles 1a are attached at fixed intervals to the receiving grooves 112.

The sub-process for preparing the nanoparticle receiving substrate 200 may be carried out by attaching the lower substrate 210 to the lower multistage 220. The lower pattern 211 is formed on the upper surface of the lower substrate 210. In the lower pattern 211, the plurality of nanogrooves 300 are provided at fixed intervals.

There is no need to set a specific process sequence of the sub-processes for preparing the nanoparticle transfer substrate 100 and preparing the nanoparticle receiving substrate 200.

The preparing process may include a preliminary measurement process. For this, it is necessary to prepare measurement standard. The measurement standard may be obtained through the process for measuring the coordinate positions of the respective upper pattern 111 and lower pattern 211 in the upper substrate 110 and lower substrate 210. This measurement standard may be used for the correction process on the precise adjustment of the upper substrate 110 and lower substrate 210. That is, the upper and lower substrates 110 and 210 are photographed by the use of SEM (scanning electron microscopy), to thereby sense the position to be measured by the sensors 130 and 230, the pattern coordinates of the nanogroove 300, and the pattern coordinates of the nanoparticle.

Also, the preliminary measurement process may include a process for presetting the measurement origin in the z-axis direction by measuring the origin position of the z-axis. In more detail, before attaching the nanoparticle 1a to the upper substrate 110, the upper substrate 110 is placed onto the lower substrate 210, and then a press is applied thereto. Under these conditions, the position of the upper substrate 110 is measured by the use of sensors 130 and 230 sensing the respective directions, and the measured position is set as the origin. Then, the contact position between the upper substrate 110 and the lower substrate 210 is determined based on the set origin.

Also, the preliminary measurement process may be carried out with steps of mounting the upper substrate 110 with the nanoparticle 1a attached thereto on the vacuum holder; lowering the upper substrate 110 being watched through the use of monitor (not shown); and lifting the upper substrate 110 after fixing the upper substrate 110 attached by vacuum through the use of adjustment pin.

Also, the preliminary measurement process may be carried out with steps of moving the lower substrate 210 to the measuring position of the sensor 130 and 230 of the x-y plane by lifting the lower substrate 210 about 1mm from a manual lever; measuring the position of the lower substrate 210; and moving the lower substrate 210 to its initial position.

As shown in FIG. 7(a), a process for bringing the nanoparticle transfer substrate 100 and nanoparticle receiving substrate 200 close to each other is carried out. Under the circumstance that the nanoparticle transfer substrate 100 is positioned above the nanoparticle receiving substrate 200, the nanoparticle transfer substrate 100 is moved downward by the use of driving means (not shown), and is brought close to the nanoparticle receiving substrate 200. In this case, an interval between the upper substrate 110 and the lower substrate 210 is adjusted to about 1µm by the use of CCD (charge coupled device) 400.

Then, as shown in FIG. 7(b), a process for measuring a distance between the nanoparticle transfer substrate 100 and the nanoparticle receiving substrate 200, and measuring the pattern position is carried out. This enables to precisely position the nanoparticles 1a right above the aimed nanogrooves 300. The respective upper sensors 130 sense and measure the position and distance of the corners of the confronting lower substrate 210; and move the upper substrate 110 to the six directions of the x-axis, y-axis and z-axis on the basis of the measured results and the aforementioned pre-measured results, whereby the respective corners of the upper and lower substrates 110 and 210 correspond with the patterned portions.

This process will be explained in detail as follows. First, the upper substrate 110 is lowered and positioned close to the lower substrate 210 while being watched through the use of monitor, whereby the upper substrate 110 and lower substrate 210 are positioned within measuring ranges of the respective sensors 130 and 230. After that, under the circumstance that the upper and lower substrates 110 and 210 are slightly apart from each other, the upper substrate 110 is adjusted so that the respective upper and lower substrates 110 and 210 are positioned at the same distance from the previously-set standard origin position. Then, the upper substrate 110 is lowered more so that the pattern of nanogroove 300 and the position of nanoparticle 1a are sensed based on the data of upper and lower substrates 110 and 210, which is previously obtained during the aforementioned preliminary process, and the measured data of the upper substrate 110. After the upper substrate 110 is lowered to the position which is somewhat higher than the position for separating the nanoparticles 1a, the precise adjustment is accomplished by re-sensing the position of x-axis, y-axis and z-axis, and then the upper substrate 110 is lowered to the position for separating the nanoparticles 1a.

Then, after the nanoparticles 1a are separated from the upper substrate 110, as shown in FIG. 7(c), the separated nanoparticles 1a are respectively positioned in the nanogrooves 300, to thereby form a single layer with the nanoparticles 1a respectively arranged in the plural nanogrooves 300 at fixed intervals.

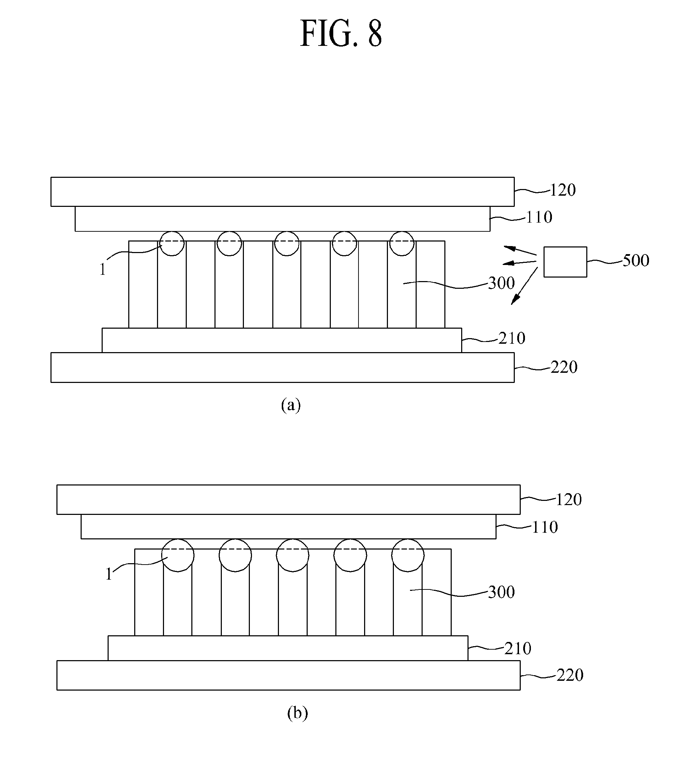

A method for separating the nanoparticles 1a from the upper substrate 110 is shown in FIG. 8(a). The nanogrooves 300 are heated by the heat treatment means 500 so that the lower pattern 211 provided with the nanogrooves 300 expands, whereby the nanoparticles 1a are stably held in the nanogrooves 300. Under this condition, the nanoparticles 1a are separated from the upper substrate 110. For easily inserting the nanoparticle 1a into the nanogroove 300, it is preferable that the diameter of nanoparticle 1a be within a range of 85 ∼ 95% of the width of nanogroove 300. Another method for separating the nanoparticles 1a from the upper substrate 110 is shown in FIG. 8(b). The nanoparticles 1a may be separated from the upper substrate 110 by forcible insertion and holding in the nanogroove 300. For tightly holding the nanoparticles 1a in the nanogrooves 300, it is preferable that the width of nanogroove 300 be within a range of 85 ∼ 95% of the diameter of nanoparticle 1.

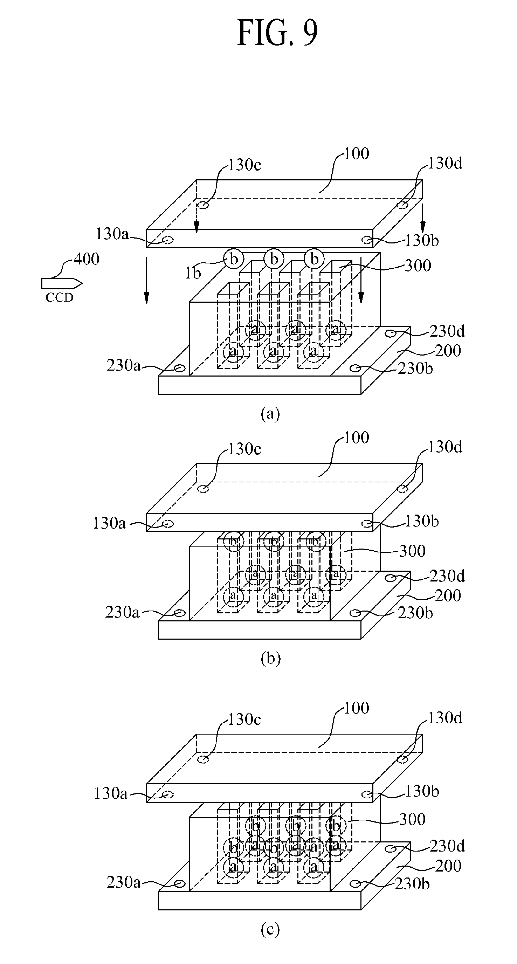

According to another embodiment of the present invention, there is shown a method for arranging the nanoparticles in a multi-layered structure. FIG. 9 is a schematic view of a process for arranging nanoparticles 1b in a double-layered structure according to one embodiment of the present invention. As shown in FIG. 9, two layers of nanoparticles 1a and 1b may be obtained by the same process as the aforementioned process for forming the single layer of nanoparticles. However, a function of the nanoparticles 1b in the second layer may be different from that of the nanoparticles 1a in the first layer.

As mentioned above, two or more nanoparticle layers 1 may be obtained by depositing the nanoparticles 1a and 1b. For example, ten or more nanoparticle layers 1 may be obtained.

After forming the plural nanoparticle layers 1 by depositing the nanoparticles 1, a process for applying heat to the nanoparticle layers 1 may be carried out for the mutual bond of nanoparticles 1, to thereby form the plural nanoparticle layers 1 with highly improved form stability.

According to the present invention, there is proposed an apparatus and method for arranging a large amount of nanoparticles with the different functions at precise positions among spacers of various materials, which enables to expect various applications.

### Industrial Applicability

Accordingly, the column-shaped structure obtained by depositing the nanoparticles according to the present invention may be used in various fields of new type photonic crystal, waveguide, photocatalytic, and etc.

## Claims

1. An apparatus for arranging nanoparticles comprising:
a nanoparticle transfer substrate having an upper substrate to which nanoparticles are to be attached;
a nanoparticle receiving substrate having a lower substrate confronting the upper substrate, wherein the nanoparticles attached to the upper substrate are separated therefrom and are to be positioned on the lower substrate;
a plurality of nanogrooves in the lower substrate, the nanogrooves inducing the nanoparticles to be arranged at predetermined positions; and
a sensor for sensing a distance between the upper substrate and the lower substrate, and positions of the nanoparticles and nanogrooves.

2. The apparatus of claim 1, further comprising a CCD (charge coupled device) for adjusting an interval between the upper substrate and the lower substrate.

3. The apparatus of claim 1, wherein the upper and lower substrates are respectively attached to upper and lower multistages capable of moving three-dimensionally.

4. The apparatus of claim 1, wherein the upper and lower substrates have patterned shapes.

5. The apparatus of claim 1, further comprising an SEM (scanning electron microscopy) for photographing the patterned shape to sense the position of the respective nanoparticles and nanogrooves.

6. The apparatus of claim 1, wherein the upper and lower substrates are formed of metal, semiconductor, or insulator.

7. The apparatus of claim 1, wherein a width of the nanogroove is about 10 ∼ 10,000nm, and a height of nanogroove is about 30 ∼ 100,000nm.

8. The apparatus of claim 1, wherein a material for forming the nanogroove includes photoresistor, polymer, silicon substrate, or electrode material.

9. The apparatus of claim 1, wherein the width of nanogroove is within a range of 85 ∼ 95% of the average diameter of nanoparticle.

10. The apparatus of claim 1, wherein the average diameter of nanoparticle is about 10 ∼ 10,000nm.

11. The apparatus of claim 1, wherein the average diameter of nanoparticle is within a range of 85 ∼ 95% of the width of nanogroove.

12. The apparatus of claim 1, wherein three or more sensors are provided on each of the upper and lower multistages.

13. The apparatus of claim 1, wherein the upper substrate is smaller than the lower substrate in size.

14. A method for arranging nanoparticles comprising:
preparing a nanoparticle transfer substrate provided with an upper substrate whose one surface has nanoparticles to be attached thereto;
preparing a nanoparticle receiving substrate provided with a lower substrate whose one surface has plural nanogrooves to be formed therein;
bringing the upper and lower substrates close to each other;
measuring a distance between the upper and lower substrates, and sensing pattern positions of the upper and lower substrates by the use of sensor; and
separating the nanoparticles from the upper substrate, and positioning the separated nanoparticles in the plural nanogrooves.

15. The method of claim 14, wherein the processes for preparing the nanoparticle transfer substrate and preparing the nanoparticle receiving substrate include preliminary measurement processes.

16. The method of claim 14, wherein each of the upper and lower substrates has a predetermined-sized pattern shape therein.

17. The method of claim 14, wherein the process for bringing the upper and lower substrates close to each other includes adjusting an interval between the upper and lower substrates by the use of CCD (charge coupled device).

18. The method of claim 14, wherein the processes for measuring the distance between the upper and lower substrates, and sensing the pattern position of the upper and lower substrates are carried out through the use of three or more sensors provided in each of upper and lower sides.

19. The method of claim 14, wherein the process for sensing the pattern position of the upper and lower substrates is carried out through the use of SEM (scanning electron microscopy).

20. The method of claim 14, further comprising forming multiple layers of nanoparticles in a method of depositing the nanoparticles in the plural nanogrooves by repeatedly carrying out the above processes.

21. The method of claim 20, wherein the multiple layers of nanoparticles include two or more layers.

22. The method of claim 20, further comprising mutually bonding the multiple layers of nanoparticles.

23. The method of claim 14, wherein the process for separating the nanoparticles from the upper substrate, and positioning the separated nanoparticles in the plural nanogrooves includes inserting the nanoparticles into the plurality of nanogrooves, and applying heat to the plurality of nanogrooves so as to stably hold the nanoparticles therein by a volume expansion.

24. The method of claim 14, wherein the process for separating the nanoparticles from the upper substrate, and positioning the separated nanoparticles in the plural nanogrooves includes forcibly inserting the nanoparticles into the plurality of nanogroove whose width is within a range of 85 ∼ 95% of the average diameter of nanoparticle.

25. The method of claim 14, wherein the nanoparticle is formed of metal, semiconductor, or insulator.

26. The method of claim 14, wherein the nanoparticle is formed in shape of sphere, ellipse, pentagonal column, hexagonal column, heptangular column, octagonal column, circular column, hexahedron, hexagonal column having rounded corners, or hexahedron having rounded corners.
